# EUROPÄISCHE PATENTSCHRIFT

(11) **EP 0 560 718 B1**
(45) Veröffentlichungstag und Bekanntmachung des Hinweises auf die Patenterteilung: **03.12.1997**
(21) Anmeldenummer: 93810148.2
(22) Anmeldetag: 01.03.1993
(51) Int. Cl.: G11C 5/00

(54) **Elektronischer Festspeicher**
Electronic read-only memory
Mémoire morte électronique

(30) Priorität: 10.03.1992 CH 757/92
(43) Veröffentlichungstag der Anmeldung: 15.09.1993
(73) Patentinhaber: FRAMA AG, CH-3438 Lauperswil (CH)
(72) Erfinder: Haug, Werner, CH-3550 Langnau (CH)
(74) Vertreter: Quehl, Horst Max, Dipl.-Ing.

(56) Entgegenhaltungen:
- US-A- 4 654 829
- PATENT ABSTRACTS OF JAPAN vol. 9, no. 227 (P-388) (1950) 13. September 1985 & JP-A-60 083 287 (MATSUSHITA DENKI SANGYO KK) 11. Mai 1985
- WESCON TECHNICAL PAPERS, Bd.30, Nr.8/2, 18. November 1986, NORTH HOLLYWOOD US Seiten 1 - 7 SHARPENBERG 'User insertable nonvolatile RAM'
- MACHINE DESIGN, Bd.58, Nr.1, Januar 1986, CLEVELAND US Seite 56 'IC module protects leads and memories'

## Beschreibung

Die Erfindung betrifft einen elektronischen Festspeicher, mit einer in einem Gehäuse eingeschlossenen Speichereinheit (PROM), die zahlreiche an der Gehäusebasis angeordnete Anschlussdrähte für die elektrische Verbindung mit einer elektrischen Leiterplatte hat.

Aus "MACHINE DESIGN, Bd. 58, Nr. 1, Januar 1986, CLEVELAND US, Seite 56, `IC MODULE protects leads and memories'" ist ein IC Modul bekannt, bei dem die Kontakte in den Innenraum des Moduls zurückversetzt sind.

Für zahlreiche elektronische Geräte, wie z.B. Billettautomaten, Frankiermaschinen u.s.w. ist es erforderlich, nach einiger Gebrauchszeit und zur Anpassung an neue Gegebenheiten, elektronische Festspeicher auszutauschen. Bei diesem Austausch kommt es häufig vor, dass durch unbeabsichtigten Kontakt mit einem der Anschlussdrähte eine Beschädigung mit Verfälschung des Speicherinhaltes erfolgt. Somit erfordert dieser Austausch eine sorgsame Handhabung durch den Fachmann und es müssen dabei Spezialwerkzeuge verwendet werden.

Der Erfindung liegt die Aufgabe zugrunde, den genannten Nachteil bekannter Festspeicher zu vermeiden und einen Festspeicher zu finden, der sich schnell und auf einfache Weise gegen einen anderen oder neuen austauschen lässt. Ausserdem soll er widerstandsfähig sein, so dass eine unsorgfältige Handhabung zu keinen Störungen führt. Die Lösung dieser Aufgabe erfolgt erfindungsgemäss dadurch, dass die Gehäusebasis der Speichereinheit an einer sekundären elektrischen Leiterplatte befestigt ist, von deren über das Gehäuse der Speichereinheit abstehenden Rand sich neben dem Gehäuse angeordnete, zahlreiche zapfenförmige Kontaktelemente wegerstrecken, und dass eine Gehäusekappe vorgesehen ist, die das Gehäuse der Speichereinheit, die Sekundärleiterplatte sowie die Kontaktelemente umschliesst, wobei das freie Ende der Kontaktelemente gegenüber der Ebene des Oeffnungsrandes der Gehäusekappe in deren Innenraum zurückversetzt ist.

Dadurch dass die aus einem Stift oder einer zur Aufnahme eines Stiftes ausgebildeten zapfenförmigen Kontaktelemente zurückversetzt in der Gehäusekappe angeordnet sind, sind sie gut gegen unbeabsichtigte Berührung geschützt.

Die ebenfalls stabförmigen Kontaktgegenelemente sind an der elektrischen Leiterplatte des Gerätes vorgesehen, das mit dem Festspeicher bestückt werden soll. Vorzugsweise ist an dieser Leiterplatte ein z.B. als kurzer Zapfen ausgebildetes Orientierungselement befestigt, das zur Aufnahme in eine Ausnehmung des Randes der Gehäusekappe bestimmt ist.

Zur weiteren Sicherung der Kontaktelemente gegen einen unzulässigen Kontakt ist in der Gehäusekappe eine innere Verschlusswand eingesetzt, die im Bereich der Kontaktelemente gegenüber dem Rand der Gehäusekappe einen Abstand aufweist, so dass ein Spaltraum frei bleibt, in dem die Kontaktelemente angeordnet sind.

Im folgenden wird die Erfindung anhand eines in den Zeichnungen dargestellten Ausführungsbeispieles erläutert. Es zeigt:
- Fig. 1: einen zentralen Querschnitt durch einen erfindungsgemässen Festspeicher in Einbauposition,
- Fig.2: einen zentralen Längsschnitt durch den Festspeicher nach Fig.1,
- Fig.3: eine Ansicht gegen die offenen Seite des nicht angeschlossenen Festspeicher,
- Fig.4: einen zentralen Querschnitt durch den Festspeicher nach Fig.3,
- Fig. 5: einen Querschnitt durch die für die Bestückung mit dem Festspeicher bestimmte Leiterplatte eines elektrischen Gerätes,
- Fig.6: einen Querschnitt durch die Gehäusekappe des Festspeichers,
- Fig.7: einen Längsschnitt der Gehäusekappe nach Fig.6 und
- Fig.8: eine Aufsicht auf eine Hälfte der Gehäusekappe.

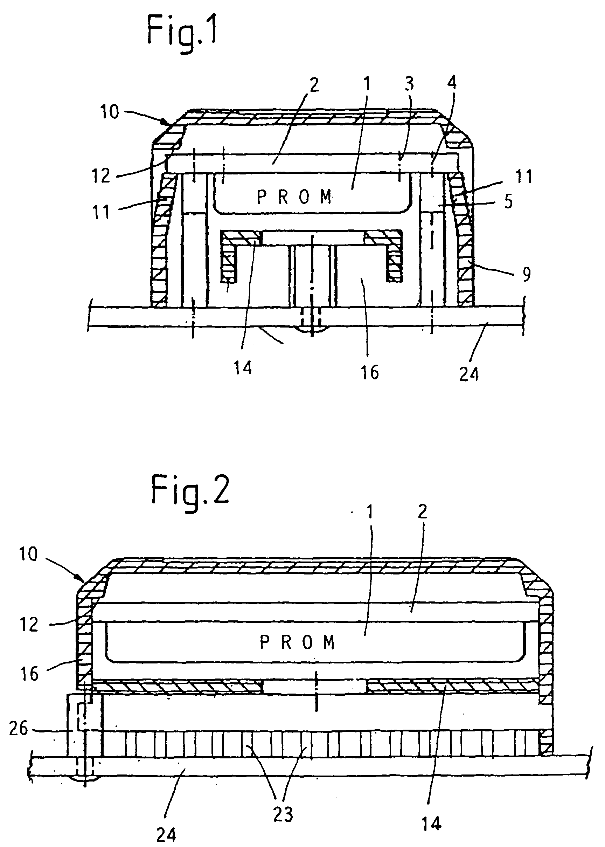

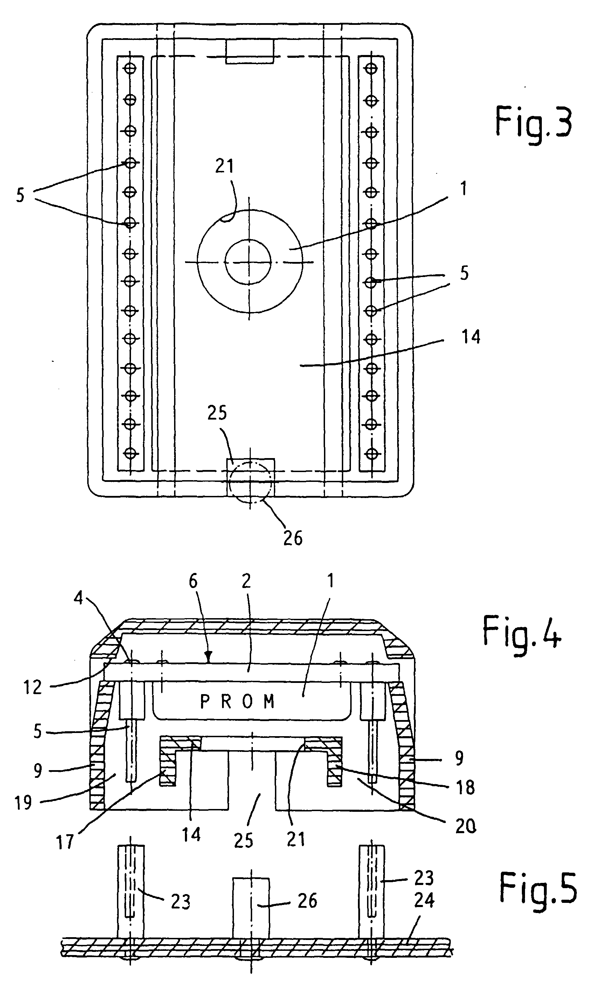

Wie die Darstellungen der Fig.1 bis 4 zeigen ist das Gehäuse 1 der Speichereinheit (PROM, EPROM u.dgl.) an der Unterseite einer sekundären Leiterplatte 2 befestigt. Ihre elektrischen Anschlussdrähte 3 erstrecken sich jeweils durch die sekundäre Leiterplatte 2 und sind auf deren Oberseite mit dem ebenfalls durch diese Leiterplatte 2 geführten, abgesetzten dünnen Ende 4 eines von der Leiterplatte 2 nach unten abstehenden, beispielsweise als Kontaktstifte 5 ausgeführten Kontaktelementes verlötet.

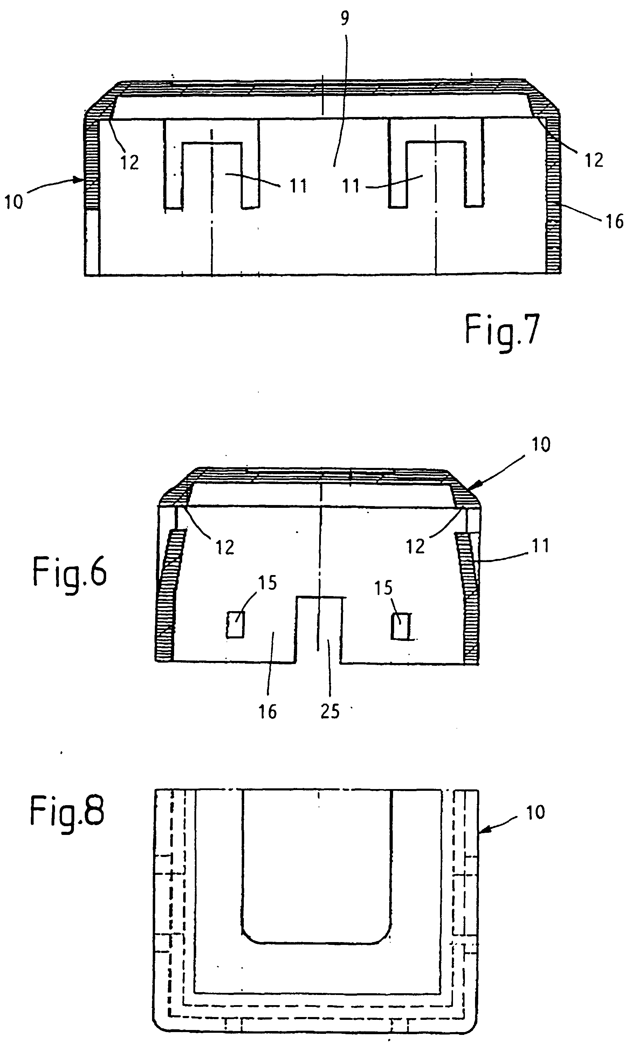

Die aus der Speichereinheit mit ihrem Gehäuse 1, der sekundären Leiterplatte 2 und den Kontaktstiften 5 bestehende innere Einrichtung 6 des Festspeichers ist in einer diese umschliessenden Gehäusekappe 7 verriegelt, die in den Fig.6 bis 8 separat dargestellt ist. Für diese verriegelte Montage der inneren Einrichtung 6 sind in zwei einander gegenüberliegenden längeren Wänden 9 der Gehäusekappe 10 schräg nach innen geneigte Federzugen 11 vorgesehen, die beim Eindrücken der sekundären Leiterplatte 2 zurückfedern und nach deren Anlage an inneren Absätzen 12 unter ihr einrasten.

Nach unten ist die Gehäusekappe 10 durch eine innere Verschlusswand 14 verriegelt. Diese hat vier seitliche Fortsätze, die in entsprechend geformte kleine Oeffnungen 15 eingreifen, die in den kürzeren Wänden 16 der Gehäusekappe 10 vorgesehen sind. Die längeren, nach unten abgewinkelten Ränder 17,18 der Verschlusswand 14 haben gegenüber den längeren Wänden 9 der Gehäusekappe 10 einen Abstand, so dass zwei Spalträume 19,20 gebildet sind, die die Kontaktstifte 5 einschliessen und sie gegen Berührung schützen. Dabei ist das freie Ende der Ränder 17,18 der Verschlusswand 14 gegenüber dem Oeffnungsrand der Gehäusekappe 10 zurückversetzt, so dass das Aufsetzen des Festspeichers auf den entsprechenden Bereich der zu bestückenden Leiterplatte 24 und das Herstellen der Steckverbindung zwischen den kontaktelementen 5,23 erleichtert wird. Das freie Ende der Kontaktstifte 5 ist auch gegenüber diesen abgewinkelten Rändern 17,18 der Verschlusswand 14 zurückversetzt, so dass ein guter Berührungsschutz gewährleistet ist.

In der Mitte der Verschlusswand 14 befindet sich eine Zugriffsöffnung 21, die zu Programmierzwecken einen Zugriff zu der in dem Gehäuse 1 eingeschlossenen Speichereinheit ermöglicht.

Damit nicht ein seitenverkehrtes Einstecken der zahlreichen Kontaktstifte 5 in die zugeordneten, zapfenförmigen Kontaktbuchsen 23 der Leiterplatte 24 eines mit dem Festspeicher bestückten Gerätes möglich ist, ist in einer der kürzeren Wände 16 der Gehäusekappe 10 eine Ausnehmung 25 vorhanden, und an entsprechender Position befindet sich an der Leiterplatte 24 ein als Zapfen 26 ausgeführtes Orientierungselement, das von der Ausnehmung aufgenommen wird, wenn die richtige Steckposition für die Herstellung des Eingriffs zwischen den Kontaktelementen 5,23 erreicht ist.

## Patentansprüche

1. Elektronischer Festspeicher mit einer in einem Gehäuse (1) eingeschlossenen Speichereinheit, die zahlreiche an der Gehäusebasis angeordnete Anschlussdrähte (3) für die elektrische Verbindung mit einer elektrischen Leiterplatte (24) hat, wobei die Gehäusebasis der Speichereinheit an einer sekundären elektrischen Leiterplatte (2) befestigt ist, dadurch gekennzeichnet, daß von dem über das Gehäuse (1) der Speichereinheit abstehenden Rand der sekundären elektrischen Leiterplatte sich neben dem Gehäuse (1) angeordnete, zahlreiche zapfenförmige Kontaktelemente (5) wegerstrecken, und dass eine Gehäusekappe (10) vorgesehen ist, die das Gehäuse (1) der Speichereinheit, die sekundäre Leiterplatte (2) sowie die Kontaktelemente (5) umschliesst, wobei das freie Ende der Kontaktelemente (5) gegenüber der Ebene des Oeffnungsrandes der Gehäusekappe (10) in deren Innenraum zurückversetzt ist.

2. Festspeicher nach Anspruch 1, dadurch gekennzeichnet, dass in die Gehäusekappe (10) eine Verschlusswand (14) eingesetzt ist, so dass das Gehäuse (1) der Speichereinheit sich hinter dieser Verschlusswand (14) befindet, wobei zwischen der Wand (9) der Gehäusekappe (10) und der Verschlusswand (14) mindestens ein Spaltraum (19,20) vorhanden ist, in dem sich die Kontaktelemente (5) befinden.

3. Festspeicher nach Anspruch 2, dadurch gekennzeichnet, dass die eingesetzte Verschlusswand (14) durch abgewinkelte Ränder (17,18) einen u-förmigen Querschnitt hat, so dass die abgewinkelten Ränder (17,18) den Spaltraum (19,20 begrenzen.

4. Festspeicher nach Anspruch 3, dadurch gekennzeichnet, dass das freie Ende der abgewinkelten Ränder (17,18) gegenüber dem Oeffnungsrand der Gehäusekappe (10) zurückversetzt ist, wobei das freie Ende der Kontaktelemente (5) gegenüber dem freien Ende der abgewinkelten Ränder (17,18) zurückversetzt ist.

5. Festspeicher nach einem der Ansprüche 1 bis 4, dadurch gekennzeichnet, dass die sekundäre Leiterplatte (2) hinter federnden Zungen (11) der Wand (9) der Gehäusekappe (10) eingerastet gehalten ist.

6. Festspeicher nach einem der Ansprüche 1 bis 5, dadurch gekennzeichnet, dass im Rand der Gehäusekappe (10) eine Ausnehmung (25) vorgesehen ist, die bestimmt ist, ein von der elektrischen Leiterplatte (24) eines mit dem Festspeicher auszurüstenden Gerätes abstehendes Orientierungselement (26) aufzunehmen.

## Claims

1. An electronic read-only memory with a memory unit enclosed in a casing (1) and which has numerous connecting wires (3), located on the casing base, for electrical connection to an electric circuit board (24), wherein the casing base of the memory unit is fixed to a secondary electric circuit board (2), characterized in that from the edge of the secondary electric circuit board projecting over the memory unit casing (1) extend away numerous, pin-shaped contact elements (5) positioned alongside the casing (1), and that a casing cap (10) is provided, which surrounds the casing (1) of the memory unit, the secondary circuit board (2) and the contact elements (5), the free end of the contact elements (5) being set back with respect to the plane of the opening edge of the casing cap (10) in the interior thereof.

2. A read-only memory according to claim 1, wherein a closure wall (14) is inserted in the casing cap (10), so that the casing (1) of the memory unit is located behind said closure wall (14) and between the wall (9) of the casing cap (10) and the closure wall (14) is provided at least one gap (19,20) housing the contact elements (5).

3. A read-only memory according to claim 2, wherein the inserted closure wall (14) has a U-shaped cross-section as a result of the angled edges (17,18), so that the latter define the gap (19,20).

4. A read-only memory according to claim 3, wherein the free end of the angled edges (17,18) is set back with respect to the opening edge of the casing cap (10), the free end of the contact elements (5) being set back with respect to the free end of the angled edges (17,18).

5. A read-only memory according to one of the claims 1 to 4, wherein the secondary circuit board (2) is held locked behind resilient tongues (11) of the wall (9) of the casing cap (10).

6. A read-only memory according to one of the claims 1 to 5, wherein a recess is provided in the edge of the casing cap (10) for receiving an orientation element (26) projecting from the electric circuit board (24) of a device to be equipped with the read-only memory.

## Revendications

1. Mémoire électronique avec une unité de mémoire enfermée dans un boîtier (1), unité de mémoire qui présente de nombreux conducteurs de connexion (3) disposés à la base du boîtier pour la connexion électrique avec une carte à circuits imprimés (24) où la base du boîtier de l'unité de mémoire est fixée à une carte à circuits imprimés secondaire (2), caractérisé en ce que depuis le bord de la carte à circuits imprimés secondaire, bord qui fait protubérance sur le boîtier (1) de l'unité de mémoire, sont issus de nombreux éléments de contact (5) en forme de tenon, situés à côté du boîtier (1) et en ce qu'un capuchon de boîtier (10) est prévu, qui enveloppe le boîtier (1) de l'unité de mémoire, la carte à circuits imprimés secondaire (2) ainsi que les éléments de contact (5) et en ce que l'extrémité libre des éléments de contact (5) est, à l'égard du plan (10) du bord de l'ouverture du capuchon de boîtier, décalée vers l'arrière jusque dans l'enceinte intérieure de ce capuchon.

2. Mémoire électronique suivant la revendication 1, caractérisée en ce que dans le capuchon (10) du boîtier est montée une cloison de fermeture (14), de sorte que le boîtier (1) de l'unité de mémoire se trouve derrière cette cloison de fermeture (14), et en ce qu'entre la cloison (9) du capuchon de boîtier (10) et la cloison de fermeture (14) il subsiste au moins une fente (19, 20) dans laquelle se trouvent les éléments de contact (5).

3. Mémoire électronique suivant la revendication 2, caractérisée en ce que par suite de ses bords coudés (17, 18), la cloison de fermeture (14) insérée présente une section transversale en forme de U, de sorte que les bords coudés (17, 18) délimitent la fente (19, 20).

4. Mémoire électronique suivant la revendication 3, caractérisée en ce que l'extrémité libre des bords coudés (17, 18) est décalée vers l'arrière à l'égard du bord d'ouverture du capuchon de boîtier (10), et en ce que l'extrémité libre des éléments de contact (5) est décalée vers l'arrière à l'égard de l'extrémité libre des bords coudés (17, 18).

5. Mémoire électronique suivant l'une quelconque des revendications de 1 à 4, caractérisée en ce que la carte à circuits imprimés secondaire (2) est maintenue par encliquetage derrière des languettes élastiques (11) de la cloison (9) du capuchon de boîtier (10).

6. Mémoire électronique suivant l'une quelconque des revendications de 1 à 5, caractérisée en ce que dans le bord du capuchon de boîtier (10) est prévu un évidement (25), destiné à recevoir un élément d'orientation (26) issu de la carte à circuits imprimés (24) d'un appareil qui doit être équipé de la mémoire électronique.
